# EUROPÄISCHE PATENTSCHRIFT

(11) **EP 1 094 328 B1**
(45) Veröffentlichungstag und Bekanntmachung des Hinweises auf die Patenterteilung: **27.07.2005**
(21) Anmeldenummer: 00122905.3
(22) Anmeldetag: 20.10.2000
(51) Int. Cl.: G01R 33/07

(54) **Magnetfeldsensor mit Kettenleiterfilter**
Magnetic field sensor with recurrent filter
Capteur de champs magnétique avec filtre récurrent

(30) Priorität: 22.10.1999 DE 19951045
(43) Veröffentlichungstag der Anmeldung: 25.04.2001
(73) Patentinhaber: Micronas GmbH, 79108 Freiburg (DE)
(72) Erfinder: Motz, Mario, Dipl.-Ing., 9241 Wernberg (AT)
(74) Vertreter: Schaumburg, Thoenes, Thurn, Landskron

(56) Entgegenhaltungen:
- EP-A- 0 793 075
- WO-A-99/21023
- DE-A- 4 431 703
- US-A- 5 621 319
- KHOURY J M: "DESIGN OF A 15-MHZ CMOS CONTINUOUS-TIME FILTER WITH ON-CHIP TUNING" IEEE JOURNAL OF SOLID-STATE CIRCUITS,US,IEEE INC. NEW YORK, Bd. 26, Nr. 12, 1. Dezember 1991 (1991-12-01), Seiten 1988-1997, XP000272860 ISSN: 0018-9200

## Beschreibung

Die Erfindung betrifft einen Magnetfeldsensor mit einem Hallelement und mit einem Orthogonalumschalter, der zwischen Anschlüssen für den Versorgungsstrom für das Hallelement und Anschlüssen für die Hallspannung abhängig von einem Taktsignal hin- und herschaltet, und mit einer Filterschaltung, die das vom Orthogonalumschalter gelieferte Signal filtert.

Ein derartiger Magnetfeldsensor ist aus der DE-A-44 31 703 derselben Anmelderin bekannt. Aufgrund der Orthogonalumschaltung wird die am Hallelement auftretende Offsetspannung im zeitlichen Mittel weitgehend eliminiert, wodurch die Meßgenauigkeit insgesamt erhöht wird. Nachteilig beim bekannten Magnetfeldsensor ist, daß infolge der Orthogonalumschaltung das Ausgangssignal über die Zeit gesehen nicht exakt konstant ist, sondern zu den Umschaltzeitpunkten ergibt sich ein diskontinuierlicher Verlauf, weil die Offsetspannung die Hallspannung rechteckförmig überlagert und bei den Umschaltzeitpunkten für kurze Zeit der Betriebszustand infolge von immer vorhandenen Schaltdifferenzen nicht definiert ist. Das Ausgangssignal ist damit mindestens an diesen Umschaltzeitpunkten fehlerbehaftet und kann nicht ausgewertet werden. Es gibt nun zahlreiche Anwendungsfälle, bei denen das Ausgangssignal des Magnetfeldsensors zeitkontinuierlich ausgewertet werden soll, beispielsweise bei der Zahnflankenerfassung an Kurbelwellen oder an Nockenwellen im Automobil. Bei diesen Anwendungen ist das Ausgangssignal des Magnetfeldsensors mit einer hohen zeitlichen Auflösung weiterzuverarbeiten.

Aus der EP-A-0 793 075 derselben Anmelderin ist eine monolithisch integrierte Sensorschaltung bekannt, die einen Orthogonal-Umschalter für die Orthogonal-Umschaltung von Signalen eines Hall-Elementes umfasst. Mit Hilfe dieser Orthogonal-Umschaltung kann ein Offset-Fehler am Sensor auf einem kleinen Wert gehalten werden. Der Verstärker ist in zwei Stufen aufgeteilt und arbeitet nach dem Chopper-Betrieb synchron mit der Orthogonal-Umschaltung. Eine erste Stufe des Verstärkers erfüllt die Funktion der Signalverstärkung des vom Sensor gelieferten Differenzsignals. Die nachgeschaltete zweite Stufe ist kapazitiv mittels zweier Kondensatoren zurückgekoppelt und hat ein Tiefpaßverhalten. Damit kommt dieser zweiten Stufe die Funktion einer Mittelwert bildenden Kombinationsstufe zu. Jeder dieser Kondensatoren wirkt als Integrator und koppelt das Ausgangssignal direkt auf den invertierten oder den nicht-invertierten Eingang zurück.

Es ist Aufgabe der Erfindung, einen Magnetfeldsensor anzugeben, dessen Ausgangssignal über die Zeit gesehen kontinuierlich ist und mit einer hohen Genauigkeit das vom Hallelement erfaßte Magnetfeld abbildet.

Diese Aufgabe wird durch die Merkmale des Anspruchs 1 gelöst. Vorteilhafte Weiterbildungen sind in den abhängigen Ansprüchen angegeben.

Die Erfindung verwendet als Filterschaltung ein Kettenleiterfilter, bei dem der je Stufe enthaltene Kondensator in der ersten Taktphase mit dem gegebenenfalls verstärkten Differenzsignal und in der zweiten Taktphase mit dem invertierten Differenzsignal beaufschlagt wird. Aufgrund der Orthogonalumschaltung ist das im Differenzsignal enthaltene Nutzsignal, welches dem erfaßten Magnetfeld entspricht, ebenfalls in den beiden Taktphasen zueinander invers. Demgemäß werden die im Differenzsignal augrund der elektronischen Bauelemente je Filterstufe sich überlagernden Gleichtaktsignale, z.B. Offsetspannungen, im zeitlichen Mittel ausgeglichen. Derartige auftretende Gleichtaktsignale werden also insgesamt eliminiert, während das vom Orthogonalumschalter gelieferte Nutzsignal mit hoher Genauigkeit gegebenenfalls verstärkt wiedergegeben wird. Mithilfe des Kettenleiterfilters lassen sich Tiefpaßfilter mit niedriger Grenzfrequenz realisieren. Folglich kann das vom Magnetfeldsensor erzeugte und infolge des Chopperbetriebs mit Diskontinuitäten behaftete Signal über die Zeit gesehen kontinuierlich abgegeben und weiterverarbeitet werden.

Ein Ausführungsbeispiel der Erfindung verwendet als Filterschaltung ein aktives Kettenleiterfilter. Ein solches Kettenleiterfilter ist beispielsweise beschrieben in IEEE J. Solid-State Circuits, vol. SC-26, no. 12, pp. 1988 - 1997, Dec. 1991. Ein solches Kettenleiterfilter hat den Vorteil, daß es ausgezeichnete Filtercharakteristik hat und relativ einfach in CMOS-Technologie hergestellt werden kann. Als Verstärkerelemente werden vorzugsweise OTA-Bausteine (operational transconductance amplifier) verwendet, die in Gyratorschaltung arbeiten. Diese OTA-Bausteine werden auch als Transkonduktanz-Verstärker bezeichnet. Die Gyratorschaltung ermöglicht die Transformation einer Impedanz in die dazu duale Impedanz. Mithilfe der Gyratorschaltung lassen sich induktive Komponenten eines Filters unter Verwendung von Kondensatoren realisieren. Auf diese Weise ist das Kettenleiterfilter in kleiner Baugröße als monolithisch ingetrierbare Schaltung realisierbar, obwohl es in einem erheblichen Maße induktive Anteile enthält, die als passives LC-Kettenleiterfilter ein erhebliches Bauvolumen erfordern würden, um das gewünschte Filterverhalten zu erzeugen, jedoch monolithisch gar nicht darstellbar wären.

Bekanntlich haben OTA-Bausteine eine erhebliche Offsetkomponente, wodurch das Ausgangssignal des aktiven Kettenleiterfilters insgesamt eine erhebliche Offsetspannung enthält. Eine solche Offsetspannung würde die durch das orthogonale Umschalten erreichbare Meßgenauigkeit der Erfassung des Magnetfeldes wieder zerstören. Gemäß der Erfindung werden hintereinander geschaltete OTA-Bausteine im Kettenleiterfilter mit ihren Eingängen und Ausgängen in einem Chopper-Betrieb so geschaltet, daß sich die entstehenden Offsetspannungen, welche sich als Spannungen an den Kondensatoren zeigen, in aufeinanderfolgenden Taktphasen kompensieren. Hierzu werden die Ausgangsspannungen der OTA-Bausteine den Kondensatoren abhängig vom Taktsignal abwechselnd zugeführt, d.h. in einer ersten Taktphase über den invertierenden Ausgang dem ersten Kondensator und in einer zweiten Taktphase über denselben invertierenden Ausgang dem zweiten Kondensator. Entsprechend wird der nicht-invertierende Ausgang geschaltet. Auf diese Weise wird ein Chopper-Betrieb realisiert, bei dem die Offsetspannungen der OTA-Bausteine kompensiert werden und im Ausgangssignal des Kettenleiterfilters nicht mehr auftreten. Dieses Kettenleiterfilter erzeugt ein zeitkontinuierliches Ausgangssignal, wobei die Frequenz des Taktsignals durch das Tiefpaßverhalten des Kettenleiterfilters unterdrückt wird. Demgemäß steht am Ausgang des Kettenleiterfilters eine Spannung an, welche auch zu den Umschaltzeitpunkten des Orthogonalumschalters keine Diskontinuitäten hat und mit hoher zeitlicher Auflösung weiterverarbeitet werden kann. Die durch die Orthogonalumschaltung erreichbare hohe Genauigkeit der Abbildung der vom Hallelement erfaßten Magnetfeldgröße bleibt erhalten.

Ein Ausführungsbeispiel der Erfindung wird im folgenden anhand der Zeichnung erläutert. Darin zeigt:
- Figur 1: eine Schaltungsanordnung für ein Hallelement mit einem Orthogonalumschalter,
- Figur 2: den Aufbau eines Kettenleiterfilters nach Art eines Gm-C-Filters,
- Figur 3: zwei hintereinander geschaltete OTA-Bausteine des Kettenleiterfilters und deren Beschaltung,
- Figur 4: ein Ersatzschaltbild mit R-, L-, C-Elementen für den Kettenleiterfilter.

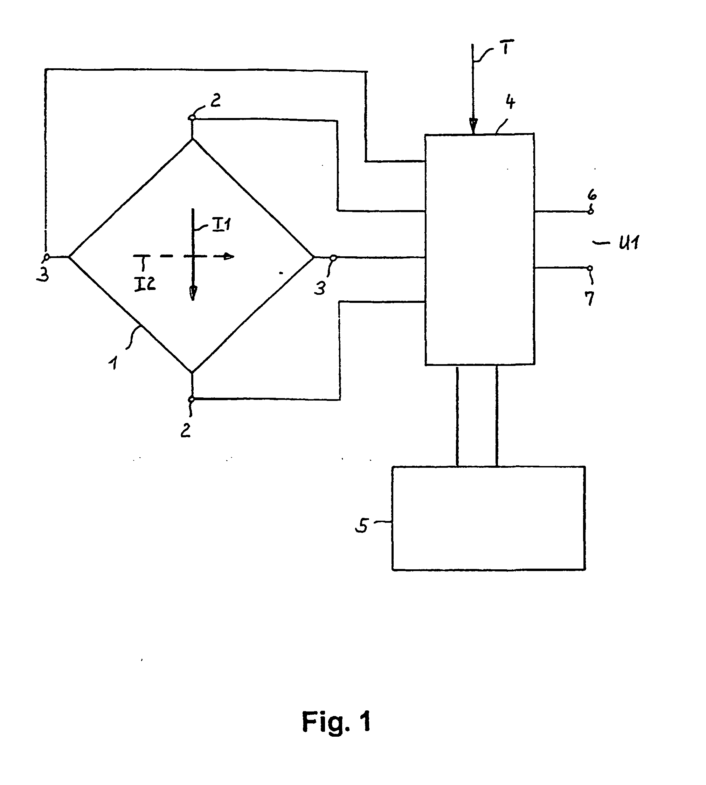

In Figur 1 ist eine Schaltungsanordnung für einen Magnetfeldsensor nach der Erfindung als Blockschaltbild dargestellt. Ein Hallelement 1 hat ein erstes Anschlußklemmenpaar 2, 2 und ein zweites Anschlußklemmenpaar 3, 3. Die Klemmen 2, 2 und 3, 3 sind mit einem Orthogonalumschalter 4 verbunden, der über ein Taktsignal T angesteuert wird. Der Orthogonalumschalter 4 ist auch mit einer Spannungsversorgungseinheit 5 verbunden, die den Steuerstrom für das Hallelement 1 bereitstellt. An den Klemmen 6, 7 des Orthogonalumschalters 4 wird die Spannung U1 abgegriffen. Der Orthogonalumschalter 4 ist so programmiert, daß er abhängig vom Taktsignal T in einer ersten Taktphase P1 über die Anschlußklemmen 2, 2 einen Strom I1 von der Spannungsversorgungseinheit 5 dem Hallelement 1 zuführt. An den Klemmen 3, 3 kann in dieser Phase P1 die Hallspannung U 1 abgegriffen werden.

In der zweiten Taktphase P1 des Taktsignals T wird der betragsmäßig gleiche Steuerstrom I2 an den Klemmen 3, 3 zugeführt; die Hallspannung wird dann an den Klemmen 2, 2 abgegriffen, d.h. die Spannung U1 entspricht der Spannung an den Klemmen 2, 2. In der Spannung U1 ist neben einer Nutzsignalkomponente, die dem Magnetfeld, dem das Hallelement 1 ausgesetzt ist, proportional ist, auch die Offsetspannung des Hallelements 1 enthalten, die infolge einer nicht idealen Geometrie des Hallelements und infolge piezoresistiver Effekte beim Verpressen des Hallelements im Kunststoffgehäuse entsteht. Die Nutzsignalkomponenten bleiben in beiden Taktphasen P1 und P2 gleich gerichtet; dagegen heben sich die Offsetsignalkomponenten in der Spannung U1 in aufeinanderfolgenden Phasen P1, P2 auf und können dadurch eliminiert werden. Eine genauere Beschreibung dieses Effektes ist in der DE-A-44 31 703 derselben Anmelderin beschrieben.

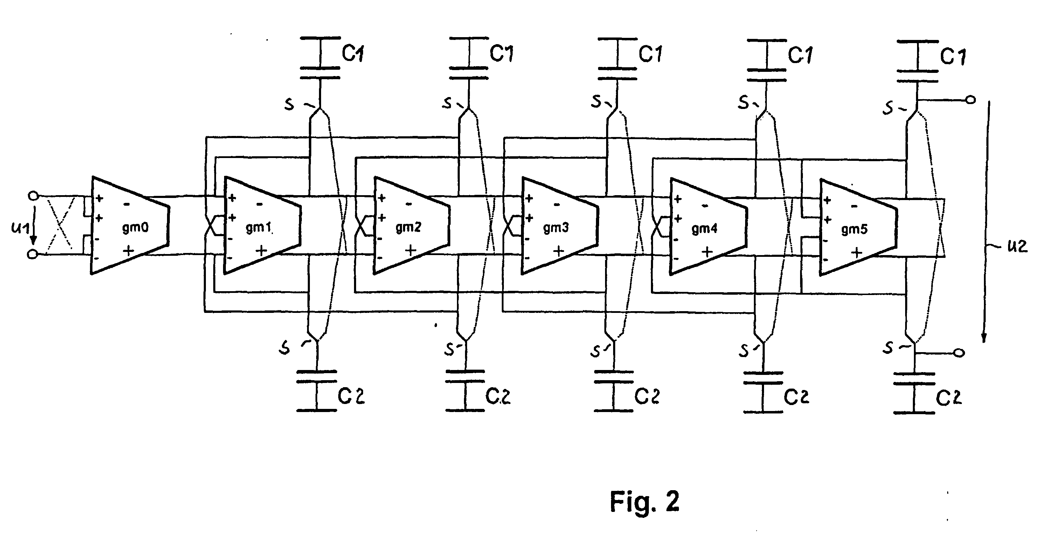

Figur 2 zeigt schematisch als Ausführungsbeispiel eine Schaltungsanordnung für ein aktives Kettenleiterfilter, das in CMOS-Technologie realisiert ist. Das Kettenleiterfilter ist vom Typ eines Gm-C-Filters, das häufig entsprechend der angelsächsischen Bezeichnung auch als Transconductance-Capacitor-Continuous-Time-Filter bezeichnet ist. Der Aufbau eines solchen Filters und das Filterverhalten ist genauer beschrieben in IEEE J. Solid-State Circuits, vol. SC-26, no. 12, pp. 1988 - 1997, Dec. 1991. Das Kettenleiterfilter nach der Erfindung enthält sechs OTA-Bausteine gm0, gm1, gm2, gm3, gm4, gm5. Die OTA-Bausteine arbeiten in Gyratorschaltung, d.h. sie erzeugen ein induktives Verhalten unter Verwendung von Kondensatoren. Auf diese Weise kann ein Tiefpaßfilter mit niedriger Grenzfrequenz und hoher Güte realisiert werden ohne daß reale Induktivitäten benötigt werden. Andere aktive Kettenleiterfilter, die beispielsweise einem RC-Kettenleiterfilter entsprechen oder statt Transkonduktanzverstärker Operationsverstärker enthalten, sind ebenfalls bei geeigneter Dimensionierung verwendbar.

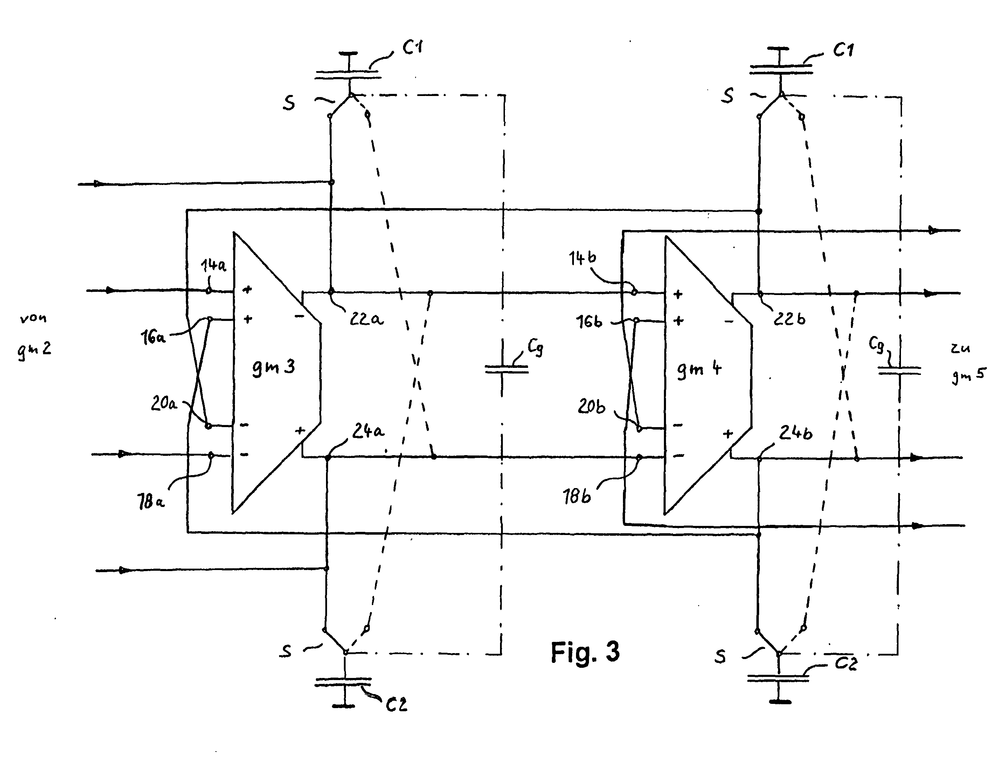

Jeder OTA-Baustein gm0 bis gm5 hat zwei invertierende Eingänge, die mit einem Minuszeichen bezeichnet sind. Weiterhin hat jeder OTA-Baustein zwei nicht invertierende Eingänge, die mit Pluszeichen gekennzeichnet sind. Die invertierenden Ausgänge der OTA-Bausteine sind mit einem Minuszeichen und die nicht invertierenden Ausgänge mit einem Pluszeichen gekennzeichnet. Der OTA-Baustein gm0 ist als Eingangsverstärker ausgebildet; die weiteren OTA-Bausteine gm1 bis gm5 sind mit ihren Ausgängen gegen Kondensatoren C1, C2 über Schalter S geschaltet. Im Ausführungsbeipiel von Figur 2 und Figur 3 sind der einfacheren Beschreibung und Darstellung wegen alle Kondensatoren C1, C2 gleich groß gewählt. Die Schalter S werden in ihre Schaltstellungen abhängig vom Taktsignal T geschaltet. In der ersten Taktphase P1 haben die Schalter S die in der Figur 2 gezeigten Stellungen. In der zweiten Taktphase P2 schalten die Schalter S um, so daß an den Kondensatoren C1, C2 jeweils die anderen Ausgänge mit umgekehrter Polarität des betreffenden OTA-Bausteins anliegen. Die Ausgangsspannung U2 des Kettenleiterfilters wird an den in Figur 2 rechts befindlichen Kondensatoren C1, C2 als Differenzspannung abgegriffen. Entgegen dem Ausführungsbeispiel von Figur 2 und Figur 3 mit zwei Kondensatoren C1, C2 an jedem OTA-Baustein ist es auch möglich, pro OTA-Baustein nur einen einzigen Kondensator Cg zu verwenden, der dann massefrei zwischen dem invertierenden und nicht-invertierenden Ausgang angeschlossen ist.

Figur 3 zeigt in einer detaillierteren Darstellung beispielhaft die Beschaltung für die OTA-Bausteine gm3 und gm4. Für die weiteren OTA-Bausteine gm1, gm2 und gm5 gilt die Beschaltung entsprechend. Die OTA-Bausteine gm3 und gm4 haben einen ersten nicht-invertierenden Eingang 14a, 14b und einen zweiten nicht-invertierenden Eingang 16a, 16b, einen ersten invertierenden Eingang 18a, 18b und einen zweiten invertierenden Eingang 20a, 20b. Weiterhin haben die OTA-Bausteine gm3, gm4 einen invertierenden Ausgang 22a, 22b und einen nicht-invertierenden Ausgang 24a, 24b. Die invertierenden Ausgänge 22a, 22b sind über Schalter S mit einem Kondensator C1 verbunden; ebenso sind die nicht-invertierenden Ausgänge 24a und 24b über Schalter S mit Kondensatoren C2 verbunden.

Das Differenzspannungssignal des vorhergehenden OTA-Bausteins gm2 ist dem OTA-Baustein gm3 an seinem ersten nicht-invertierenden Eingang 14a und an seinem ersten invertierenden Eingang 18a zugeführt. Der invertierende Ausgang 22b des nachgeschalteten OTA-Bausteins gm4 ist mit dem zweiten invertierenden Eingang 20a des OTA-Bausteins gm3 verbunden. Der nicht-invertierende Ausgang 24b des OTA-Bausteins gm4 ist mit dem zweiten nicht-invertierenden Eingang 16a des OTA-Bausteins gm3 verbunden.

Wie erwähnt wird die Schaltstellung der Schalter S abhängig vom Taktsignal T gesteuert. Die in der Figur 3 gezeigte Stellung gilt für die erste Taktphase P1. In dieser ersten Taktphase P1 sind die invertierenden Ausgänge 22a, 22b des ersten OTA-Bausteins gm3 und des zweiten OTA-Bausteins gm4 jeweils mit dem ersten Kondensator C1 verbunden. Die nicht-invertierenden Ausgänge 24a, 24b des ersten OTA-Bausteins gm3 und des zweiten OTA-Bausteins gm4 sind jeweils mit dem zweiten Kondensator C2 verbunden. In dieser Taktphase P1 werden die Kondensatoren C1, C2 entsprechend der genannten Beschaltung aufgeladen. In der zweiten Taktphase P2 werden die Schalter S in ihre andere Stellung geschaltet, welche in der Figur 3 gestrichelt dargestellt ist. Demgemäß sind die invertierenden Ausgänge 22a, 22b des ersten OTA-Bausteins gm3 und des zweiten OTA-Bausteins gm4 jeweils mit dem zweiten Kondensator C2 und die nicht-invertierenden Ausgänge 24a, 24b des ersten OTA-Bausteins gm3 und des zweiten OTA-Bausteins gm4 jeweils mit dem ersten Kondensator C1 verbunden. Die Kondensatoren C1, C2 werden dann entsprechend dieser Schaltstellung der Schalter S geladen. Durch das Hin- und Herschalten der Schalter S abhängig vom Taktsignal wird ein Chopper-Betrieb realisiert. Bei diesem Chopper-Betrieb werden ständig Signalausgänge zum Laden der Kondensatoren C1, C2 vertauscht. Dadurch werden die an den OTA-Bausteinen auftretenden Offsetsignale durch eine Mittelwertbildung über die Zeit unterdrückt. Da das Taktsignal T gleichzeitig sowohl die Schalter S als auch den Orthogonalumschalter 4 steuert, bleibt auch beim nachgeschalteten Kettenleiterfilter die Offsetspannungsunterdrückung infolge der Orthogonalumschaltung erhalten.

Die Dimensionierung der Transkonduktanzen gm der einzelnen OTA-Bausteine gm0 bis gm5 und die Größe der mitintegrierten Kondensatoren C1, C2, Cg bestimmen den Frequenzgang des Kettenleiterfilters. Die Dimensionierung der Elemente des Kettenleiterfilters wird vorzugsweise so ausgeführt, daß alle Kapazitäten als unterschiedliche Vielfache einer Grundkapazität C0 und alle Transkonduktanzen als unterschiedliche Vielfache einer Grundtranskonduktanz gm0 gewählt werden. Der Quotient gm0/C0 bestimmt dann die Grenzfrequenz des Filters während die Verstärkung durch die Verhältnisse der Transkonduktanzen zueinander bestimmt wird. Bei den rückgekoppelten OTA-Bausteinen gm1 bis gm5 im Ausführungsbeispiel von Figur 2 und Figur 3 wird die Verstärkung der jeweiligen Transkonduktanzstufe dadurch eingestellt, daß bei dem jeweiligen OTA-Baustein gm1 bis gm5 die der Signalhauptflußrichtung (entspricht in Fig. 3 den Eingängen 14a, 14b bzw. 18a, 18b) zugeordnete Transkonduktanz größer als die der Signalrückführungsrichtung (entspricht in Figur 3 den Eingängen 16a, 20a bzw. 16b, 20b) zugeordnete Transkonduktanz ist. Ist das Verhältnis dieser Transkonduktanzen gm beispielsweise 3:1, dann hat der zugehörige OTA-Baustein den Signalverstärkungsfaktor 3. Sind beide Transkonduktanzen gm gleich, dann ist der Signalverstärkungsfaktor 1 und das Signal wird in der Größe nicht verändert.

Das Kettenleiterfilter hat eine Tiefpaßfunktion. Die Filterfrequenz dieses Tiefpasses ist mindestens um den Faktor 2 kleiner als die Frequenz des Taktsignals T, welche der Chopper-Frequenz, z.B. 300 kHz entspricht. Diese Filterfrequenz ist im Ausführungsbeispiel um den Faktor 5 kleiner als die Frequenz des Taktsignals T. Typischerweise liegt dabei die Grenzfequenz des Kettenleiterfilters im Bereich von 30 kHz bis 100 kHz, vorzugsweise im Bereich von 60 kHz. Bei dieser Dimensionierung wird für ein Hallsignal, dessen Nutzsignal-Frequenzbereich von 0 Hz bis ca. 10 kHz reicht, ein kontinuierliches Ausgangssignal mit einer hohen zeitlichen Auflösung erzeugt, ohne daß Diskontinuitäten auftreten.

Bei der am Eingang des Kettenleiterfilters anstehenden Spannung U1 tritt alternierend die Summe und Differenz aus Offsetspannung des Hallelements 1 und Hallspannung auf. Am Ausgang des Kettenleiterfilters und in den Zwischensignalen des Filters wird phasenrichtig ständig die Hallspannung gebildet, d.h. die Spannungen an den Kondensatoren C1, C2 entsprechen der jeweiligen Hallspannung, die ein niederfrequentes kontinuierliches Signal oder sogar ein Gleichsignal ist. Die Offsetspannungen erscheinen an den Kondensatoren C1, C2 phasenrichtig als Wechselsignale und werden infolge der Tiefpaßfiltercharakteristik des Kettenleiterfilters weggefiltert. Am Ausgang des Kettenleiterfilters wird demgemäß die offsetfreie, tiefpaßgefilterte Spannung U2 erzeugt, die der vom Hallelement 1 abgegebenen Hallspannung entsprechend der Größe des Magnetfeldes entspricht. Gemäß der Erfindung kann also die Hallspannung das Kettenleiterfilter im Nutzsignal-Frequenzbereich, beispielsweise im Bereich von 0 Hz bis 10 kHz, ungedämpft passieren, während die Offsetspannung des Hallelements 1 und die Offsetspannungen der OTA-Bausteine gm0 bis gm5 als Wechselsignale auf die Chopper-Freuqenz, beispielsweise 300 kHz, moduliert werden. Infolge der Tiefpaßeigenschaft des Kettenleiterfilters, beispielsweise mit einer Tiefpaß-Filterfrequenz von 60 kHz, wird dieses Wechselsignal weggefiltert. Im zeitlichen Mittel bildet sich am Ausgang des Kettenleiterfilters eine Spannung U2 aus, in der die auftretenden Offsetspannungen unterdrückt sind. Das Filter kann kostenkünstig in CMOS-Technologie als Transkonduktanz-C-Filter, d.h. als Gm-C-Filter ausgeführt werden. Der gesamte Magnetfeldsensor kann somit in einer kleinen Baugröße als ein Bauelement zusammen mit dem Kettenleiterfilter als monolithisch integrierbare Schaltung realisiert werden.

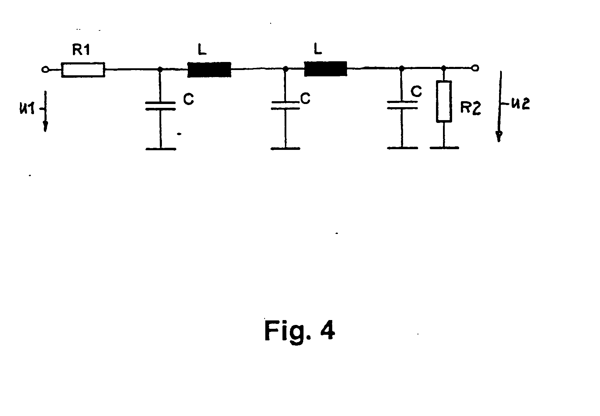

Figur 4 zeigt ein LCR-Ersatzschaltbild des in Figur 2 gezeigten Kettenleiterfilters. Die Induktivitäten L werden durch die Gyratorschaltung der OTA-Bausteine realisiert. Die Widerstände R1 und R2 werden durch Parametereinstellungen der OTA-Bausteine gm0 bis gm5 definiert. Wie zu erkennen ist, definiert das Ersatzschaltbild ein mehrstufiges Tiefpaßfilter.

## Patentansprüche

1. Magnetfeldsensor mit einem Hallelement (1) und mit einem Orthogonalumschalter (4), der zwischen Anschlüssen für den Versorgungsstrom für das Hallelement (1) und Anschlüssen für die Hallspannung abhängig von einem Taktsignal (T) hin- und herschaltet,
und mit einer Filterschaltung, die das vom Orthogonalumschalter (4) gelieferte Signal (U1) filtert,
**dadurch gekennzeichnet, daß** als Filterschaltung ein mehrstufiges Kettenleiterfilter vorgesehen ist, dem das Signal (u1) als Differenzsignal zugeführt ist,
und daß jede Stufe mindestens einen Kondensator (C1, Cg) enthält, der abhängig vom Taktsignal (T) in einer ersten Taktphase (P1) mit dem gegebenenfalls verstärkten Differenzsignal und in einer zweiten Taktphase (P2) mit dem invertierten Differenzsignal beaufschlagt ist.

2. Magnetfeldsensor nach Anspruch 1, **dadurch gekennzeichnet, daß** das Kettenleiterfilter als aktives Kettenleiterfilter ausgebildet ist, der vorzugsweise OTA-Bausteine enthält.

3. Magnetfeldsensor nach Anspruch 2, **dadurch gekennzeichnet, daß** das aktive Kettenleiterfilter mindestens zwei hintereinander geschaltete OTA-Bausteine (gm3, gm4) enthält, die in Gyratorschaltung arbeiten,
daß jeder OTA-Baustein (gm3, gm4) einen ersten nicht-invertierenden Eingang (14a, 14b) und einen zweiten nicht-invertierenden Eingang (16a, 16b), einen ersten invertierenden Eingang (18a, 18b) und einen zweiten invertierenden Eingang (20a, 20b), sowie einen invertierenden Ausgang (22a, 22b) und einen nicht-invertierenden Ausgang (24a, 24b) hat,
daß das gegebenenfalls verstärkte Signal (U1) dem ersten OTA-Baustein (gm3) am ersten nicht-invertierenden Eingang (14a) und am ersten invertierenden Eingang (18a) zugeführt ist,
daß den OTA-Bausteinen (gm3, gm4) jeweils ein erster Kondensator (C1) und ein zweiter Kondensator (C2) oder ein gemeinsamer Kondensator (Cg) zugeordnet ist,
daß der invertierende Ausgang (22b) des dem ersten OTA-Baustein (gm3) nachgeschalteten zweiten OTA-Bausteins (gm4) mit dem zweiten invertierenden Eingang (20a) des ersten OTA-Bausteins (gm3) verbunden ist,
daß der nicht-invertierende Ausgang (24b) des zweiten OTA-Bausteins (gm4) mit dem zweiten nicht-invertierenden Eingang (16a) des ersten OTA-Bausteins (gm3) verbunden ist,
daß abhängig vom Taktsignal (T) in der ersten Taktphase (P1) die invertierenden Ausgänge (22a, 22b) des ersten OTA-Bausteins (gm3) und des zweiten OTA-Bausteins (gm4) jeweils mit dem ersten Kondensator (C1) oder mit dem ersten Anschluß des gemeinsamen Kondensators (Cg) und die nicht-invertierenden Ausgänge (24a, 24b) des ersten OTA-Bausteins (gm3) und des zweiten OTA-Bausteins (gm4) jeweils mit dem zweiten Kondensator (C2) oder mit dem zweiten Anschluß des gemeinsamen Kondensators (Cg) verbunden sind,
und daß in der zweiten Taktphase (P2) des Taktsignals (T) die invertierenden Ausgänge (22a, 22b) des ersten OTA-Bausteins (gm3) und des zweiten OTA-Bausteins (gm4) jeweils mit dem zweiten Kondensator (C2) oder mit dem zweiten Anschluß des gemeinsamen Kondensators (Cg) und die nicht-invertierenden Ausgänge (24a, 24b) des ersten OTA-Bausteins (gm3) und des zweiten OTA-Bausteins (gm4) mit dem ersten Kondensator (C1) mit dem ersten Anschluß des gemeinsamen Kondensators (Cg) zur Realisierung eines Chopper-Betriebs miteinander verbunden sind.

4. Magnetfeldsensor nach Anspruch 3, **gekennzeichnet durch** weitere OTA-Bausteine (gm1, gm2, gm5) mit einer Beschaltung nach Art des ersten und zweiten OTA-Bausteins (gm3, gm4) zum Aufbau eines mehrstufigen Kettenleiterfilters.

5. Magnetfeldsensor nach einem der vorhergehenden Ansprüche, **dadurch gekennzeichnet, daß** das Kettenleiterfilter als Tiefpaßfilter mit einer Filterfrequenz mindestens um den Faktor 2 kleiner als die Frequenz des Taktsignals (T) geschaltet ist, vorzugsweise um den Faktor 5 kleiner.

6. Magnetfeldsensor nach Anspruch 5, **dadurch gekennzeichnet, daß** die Grenzfrequenz des Kettenleiterfilters im Bereich von 30 kHz bis 100 kHz, vorzugsweise im Bereich von 60 kHz liegt.

7. Magnetfeldsensor nach einem der vorhergehenden Ansprüche, **dadurch gekennzeichnet, daß** das Kettenleiterfilter in CMOS-Technologie als Transconductance-C-Filter realisiert ist.

8. Magnetfeldsensor nach einem der vorhergehenden Ansprüche 3 bis 7, **dadurch gekennzeichnet, daß** zur Realisierung des Chopper-Betriebs die Kondensatoren (C1, C2) mittels CMOS-Schalter mit den Ausgängen (22a, 22b; 24a, 24b) der OTA-Bausteine (gm3, gm4) verbunden sind.

9. Magnetfeldsensor nach einem der vorhergehenden Ansprüche 2 bis 8, **dadurch gekennzeichnet, daß** mindestens bei einem OTA-Baustein (gm1 bis gm5) die der Signalhauptflußrichtung zugeordnete Transkonduktanz größer als die der Signalrückführungsrichtung zugeordnete Transkonduktanz ist, wobei die Signalhanptflnpridchtung vom Eingangssignal in Richtung Ausgangssignal und die Signalrückführungsrichtung in dazu umgekehrter Richtung verlänft.

## Claims

1. A magnetic field sensor with a Hall element (1) and with a rectangular change-over switch (4), which switches between connections for the power supply to the Hall element (1) and connections for the Hall voltage dependent on a timing signal (T),
and with a filter circuit which filters the signal (U1) delivered by the rectangular change-over switch (4),
**characterized in that** there is provided a multi-stage ladder-type filter as the filter circuit, to which the signal (U1) is fed as a differential signal,
and that every stage contains at least one capacitor (C1, Cg) which is charged dependent on the timing signal (T) in a first timing phase (P1) with the possibly amplified differential signal and in a second timing phase (P2) with the inverted differential signal.

2. The magnetic field sensor according to claim 1, **characterized in that** the ladder-type filter is designed as an active ladder-type filter which preferably contains OTA modules.

3. The magnetic field sensor according to claim 2, **characterized in that** the active ladder-type filter contains at least two OTA modules (gm3, gm4) connected in series, which work in gyrator switching,
that each OTA module (gm3, gm4) has a first non-inverting inlet (14a, 14b) and a second non-inverting inlet (16a, 16b), a first inverting inlet (18a, 18b) and a second inverting inlet (20a, 20b), as well as an inverting outlet (22a, 22b) and a non-inverting outlet (24a, 24b),
that the possibly amplified signal (U1) is fed to the first OTA module (gm3) at the first non-inverting inlet (14a) and at the first inverting inlet (18a),
that to the OTA modules (gm3, gm4) respectively there is set a first capacitor (C1) and a second capacitor (C2) or a common capacitor (Cg),
that the inverting outlet (22b) of the second OTA module (gm4) connected in series to the first OTA module (gm3) is linked up to the second inverting inlet (20a) of the first OTA module (gm3),
that the non-inverting outlet (24b) of the second OTA module (gm4) is linked up to the second non-inverting inlet (16a) of the first OTA module (gm3),
that, dependent upon the timing signal (T) in the first timing phase (P1) the inverting outlets (22a, 22b) of the first OTA module (gm3) and of the second OTA module (gm4) are linked up respectively to the first capacitor (C1) or to the first connection of the common capacitor (Cg), and the non-inverting outlets (24a, 24b) of the first OTA module (gm3) and of the second OTA module (gm4) are linked up respectively to the second capacitor (C2) or with the second connection of the common capacitor (Cg),
and that in the second timing phase (P2) of the timing signal (T) the inverting outlets (22a, 22b) of the first OTA module (gm3) and of the second OTA module (gm4) are linked up respectively with the second capacitor (C2) or with the second connection of the common capacitor (Cg) and the non-inverting outlets (24a, 24b) of the first OTA module (gm3) and of the second OTA module (gm4) are linked up together with the first capacitor (C1) with the first connection of the common capacitor (Cg) for achievement of a chopper operation.

4. The magnetic field sensor according to claim 3, **characterized by** further OTA modules (gm1, gm2, gm5) having a wiring according to the first and second OTA modules (gm3, gm4) for construction of a multi-stage ladder-type filter.

5. The magnetic field sensor according to one of the preceding claims, **characterized in that** the ladder-type filter is switched as a low pass filter with a filter frequency at least smaller by a factor of 2 than the frequency of the timing signal (T), preferably by the factor of 5.

6. The magnetic field sensor according to claim 5, **characterized in that** the cutoff frequency of the ladder-type filter lies in a range of 30 kHz to 100 kHz, preferably in the range of 60 kHz.

7. The magnetic field sensor according to one of the preceding claims, **characterized in that** the ladder-type filter is implemented in CMOS technology as a transconductance-C-filter.

8. The magnetic field sensor according to one of the claims 3 to 7, **characterized in that**, in order to implement the chopper operation, the capacitors (C1, C2) are linked by means of CMOS switches with the outlets (22a, 22b; 24a, 24b) of the OTA modules (gm3, gm4).

9. The magnetic field sensor according to one of the claims 2 to 8,
**characterized in that** at least with one OTA module (gm1 to gm5), the transconductance set to a signal main flow direction is greater than the transconductance set to a signal feedback direction, wherein the signal main flow direction runs from the input signal toward the output signal and the signal feedback direction runs in a direction opposite thereto.

## Revendications

1. Détecteur de champ magnétique avec un élément à effet Hall (1) et un commutateur orthogonal (4), qui alterne entre la connexion servant à délivrer du courant électrique à l'élément à effet Hall (1) et la connexion pour la tension Hall en fonction d'un signal de synchronisation (T),
et filtre, à l'aide d'un circuit filtrant, le signal (U1) délivré par le commutateur orthogonal (4),
**caractérisé en ce que**, comme circuit filtrant, il est prévu un filtre conducteur en chaîne à plusieurs étages, auquel est envoyé le signal (U1) sous la forme d'un signal différentiel,
et **en ce que** chaque étage comporte au moins un condensateur (C1, Cg) qui est sollicité, en fonction du signal de synchronisation (T), pendant une première phase de synchronisation (P1), avec le signal différentiel, le cas échéant amplifié, et, pendant une deuxième phase de synchronisation (P2), avec le signal différentiel inversé.

2. Détecteur de champ magnétique selon la revendication 1, **caractérisé en ce que** le filtre conducteur en chaîne est configuré sous la forme d'un filtre conducteur en chaîne actif, qui contient de préférence des composants OTA (amplis opérationnels de transconductance).

3. Détecteur de champ magnétique selon la revendication 2, **caractérisé en ce que** le filtre conducteur en chaîne actif comporte au moins deux composants OTA (gm3, gm4) connectés l'un derrière l'autre, qui fonctionnent en circuit gyrateur,
**en ce que** chaque composant OTA (gm3, gm4) présente une première entrée non inverseuse (14a, 14b) et une deuxième entrée non inverseuse (16a, 16b), une première entrée inverseuse (18a, 18b) et une deuxième entrée inverseuse (20a, 20b), ainsi qu'une sortie inverseuse (22a, 22b) et une sortie non inverseuse (24a, 24b),
**en ce que** le signal (U1), le cas échéant amplifié, est acheminé vers le premier composant OTA (gm3) au niveau de la première entrée non inverseuse (14a) et au niveau de la première entrée inverseuse (18a),
**en ce que**, aux composants OTA (gm3, gm4), est respectivement affecté un premier condensateur (C1) et un deuxième condensateur (C2), ou un condensateur commun (Cg),
**en ce que** la sortie inverseuse (22b) du deuxième composant OTA (gm4), monté en aval du premier composant OTA (gm3), est reliée à la deuxième entrée inverseuse (20a) du premier composant OTA (gm3),
**en ce que** la sortie non inverseuse (24b) du deuxième composant OTA (gm4) est reliée à la deuxième entrée non inverseuse (16a) du premier composant OTA (gm3),
**en ce que**, en fonction du signal de synchronisation (T), pendant la première phase de synchronisation (P1), les sorties inverseuses (22a, 22b) du premier composant OTA (gm3) et du deuxième composant OTA (gm4) sont respectivement reliées au premier condensateur (C1) ou à la première borne du condensateur commun (Cg), et les sorties non inverseuses (24a, 24b) du premier composant OTA (gm3) et du deuxième composant OTA (gm4) sont respectivement reliées au deuxième condensateur (C2) ou à la deuxième borne du condensateur commun (Cg),
et **en ce que**, pendant la deuxième phase de synchronisation (P2) du signal de synchronisation (T), les sorties inverseuses (22a, 22b) du premier composant OTA (gm3) et du deuxième composant OTA (gm4) sont respectivement reliées au deuxième condensateur (C2) ou à la deuxième borne du condensateur commun (Cg), et les sorties non inverseuses (24a, 24b) du premier composant OTA (gm3) et du deuxième composant OTA (gm4) sont reliées au premier condensateur (C1), à la première borne du condensateur commun (Cg) pour obtenir un système de hachage.

4. Détecteur de champ magnétique selon la revendication 3, **caractérisé par** d'autres composants OTA (gm1, gm2, gm5), selon un câblage correspondant au type des premier et deuxième composants OTA (gm3, gm4), afin de monter un filtre conducteur en chaîne à plusieurs étages.

5. Détecteur de champ magnétique selon l'une quelconque des revendications précédentes, **caractérisé en ce que** le filtre conducteur en chaîne, sous la forme d'un filtre passe-bas, est connecté à une fréquence de filtre inférieure d'un facteur 2 à la fréquence du signal de synchronisation (T), et de préférence inférieure d'un facteur 5.

6. Détecteur de champ magnétique selon la revendication 5, **caractérisé en ce que** la fréquence limite du filtre conducteur en chaîne se trouve dans la plage comprise entre 30 kHz et 100 kHz, de préférence dans la zone de 60 kHz.

7. Détecteur de champ magnétique selon l'une quelconque des revendications précédentes, **caractérisé en ce que** le filtre conducteur en chaîne est réalisé selon la technologie CMOS, sous la forme d'un filtre C de transconductance.

8. Détecteur de champ magnétique selon l'une quelconque des revendications 3 à 7, **caractérisé en ce que**, pour mettre en oeuvre le système de hachage, les condensateurs (C1, C2) sont reliés par l'intermédiaire du commutateur CMOS aux sorties (22a, 22b ; 24a, 24b) des composants OTA (gm3, gm4).

9. Détecteur de champ magnétique selon l'une quelconque des revendications 2 à 8, **caractérisé en ce que**, au moins dans un composant OTA (gm1 à gm5), la transconductance affectée au sens du trajet principal des signaux est supérieure à la transconductance affectée au sens de restitution des signaux, moyennant quoi le sens du trajet principal des signaux va du signal d'entrée au signal de sortie, et le sens de restitution des signaux va dans le sens inverse.
